# EUROPÄISCHE PATENTANMELDUNG

(11) **EP 3 544 183 A1**
(43) Veröffentlichungstag der Anmeldung: **25.09.2019**
(21) Anmeldenummer: 18162587.2
(22) Anmeldetag: 19.03.2018
(51) Int. Cl.: H03K 17/0812

(54) **SCHALTUNGSANORDNUNG ZUM BETREIBEN EINES HALBLEITERSCHALTERS**

(71) Anmelder: Siemens Aktiengesellschaft, 80333 München (DE)
(72) Erfinder: Göpfrich, Kurt, 91058 Erlangen (DE); Roppelt, Bernd, 96191 Viereth-Trunstadt (DE); Schwinn, Thomas, 91074 Herzogenaurach (DE); Wittmann, Gerhard, 90584 Allersberg (DE)

(57) **Zusammenfassung**

Die Erfindung betrifft eine Schaltungsanordnung (1) zum Betreiben eines Halbleiterschalters (3), der einen Steueranschluss (5) und zwei Lastanschlüsse (7, 9) aufweist. Die Schaltungsanordnung (1) umfasst eine Treiberschaltung (11) zum Ansteuern des Halbleiterschalters (3) über den Steueranschluss (5), wobei die Treiberschaltung (11) einen ersten Spannungsversorgungsanschluss (17) und einen zweiten Spannungsversorgungsanschluss (19) aufweist. Ferner umfasst die Schaltungsanordnung (1) eine Treiberspannungsversorgung (13), die eine Einschaltversorgungsspannung (U₁) zwischen dem ersten Spannungsversorgungsanschluss (17) und einem ersten Lastanschluss (7) zum Einschalten des Halbleiterschalters (3) anlegt, und eine Klemmschaltung (15) zur Begrenzung einer Spannung zwischen dem Steueranschluss (5) und dem ersten Lastanschluss (7) auf eine Klemmspannung (U_{C}), die unabhängig von der Einschaltversorgungsspannung (U₁) ist.

## Beschreibung

Die Erfindung betrifft eine Schaltungsanordnung zum Betreiben eines Halbleiterschalters, der einen Steueranschluss und zwei Lastanschlüsse aufweist. Insbesondere betrifft die Erfindung eine Schaltungsanordnung zum Betreiben eines Bipolartransistors mit isoliertem Gate (IGBT = Insulated-Gate Bipolar Transistor) oder eines Metall-Oxid-Halbleiter-Feldeffekttransistors (MOSFET = Metal-Oxide-Semiconductor Field-Effect Transistor).

In einem Kurzschlussfall begrenzen Halbleiterschalter wie IGBT oder MOSFET einen Kurzschlussstrom auf einen maximalen Wert. Dies geschieht durch eine Entsättigung des Halbleiterschalters, wobei eine Spannung an dem Halbleiterschalter ansteigt und dadurch den Widerstand des Kurzschlusskreises erhöht. Allerdings wird der Halbleiterschalter dabei einer hohen Verlustleistung ausgesetzt, da sowohl ein hoher Strom durch den Halbleiterschalter fließt als auch eine hohe Spannung anliegt. Der Halbleiterschalter muss deshalb bei einem Kurzschluss von der Ansteuerung abgeschaltet werden, bevor eine vom Arbeitspunkt abhängige maximale Verlustenergie aufgenommen wird. Andernfalls wird der Halbleiterschalter so stark erhitzt, dass er zerstört wird.

Darüber hinaus bewirkt die durch die Entsättigung entstehende schnelle Änderung der Spannung über die so genannte Millerkapazität einen Verschiebestrom, der die Spannung an dem Steueranschluss über eine eigentliche Einschaltspannung erhöht. Dies öffnet wiederum den Kanal des Halbleiterschalters weiter und wirkt dadurch dem oben beschriebenen Entsättigungseffekt entgegen. Hierdurch werden die Kurzschlussströme erst bei einem höheren Niveau begrenzt, was die Verlustleistung an dem Halbleiterschalter erhöht und eine maximal mögliche Kurzschlusszeit verringert. Um dies zu vermeiden, wird üblicherweise eine so genannte Gateklemmung eingesetzt. Im einfachsten Fall ist dies eine Diode, die den Steueranschluss mit der Versorgungsspannung der Treiberschaltung zum Ansteuern des Steueranschlusses verbindet. Steigt die Spannung am Steueranschluss über die Versorgungsspannung an, wird die Diode leitend und "klemmt" die Steueranschlussspannung auf deren Wert fest, so dass diese im Kurzschlussfall nicht weiter ansteigen kann.

Bei einer Verwendung bestimmter Treiberschaltungen, beispielsweise einer Treiberschaltung mit einer Bipolar-Endstufe, muss ein Spannungsabfall an der Treiberschaltung durch eine Erhöhung der Versorgungsspannung ausgeglichen werden. Fallen beispielsweise an der Treiberschaltung zwei bis drei Volt ab, muss die Versorgungsspannung gegenüber der Einschaltspannung um zwei bis drei Volt erhöht werden. In diesem Fall würde aber bei Verwendung einer herkömmlichen Gateklemmung die Spannung am Steueranschluss im Kurzschlussfall ebenfalls gegenüber der Einschaltspannung um zwei bis drei Volt ansteigen. Der Kurzschlussstrom stellt sich dadurch auf ein höheres Niveau ein. Um zu verhindern, dass der Halbleiterschalter zerstört wird, muss der Halbleiterschalter bei einem Kurzschluss daher früher abgeschaltet werden. Bei einigen Halbleiterschaltern, beispielsweise bei IGBT neuerer Generationen, bei denen aus technischen Gründen die maximal tolerierbaren Kurzschlusszeiten und Kurzschlussenergien reduziert wurden, erfolgt ein Abschalten bei der Verwendung herkömmlicher Treiberschaltungen und Gateklemmungen jedoch nicht rechtzeitig, beziehungsweise es ist ein hoher Aufwand erforderlich, um die Reaktionszeit der Überstromabschaltung bei einem Kurzschluss ausreichend zu verkürzen.

Der Erfindung liegt die Aufgabe zugrunde, eine Schaltungsanordnung zum Betreiben eines Halbleiterschalters, der einen Steueranschluss und zwei Lastanschlüsse aufweist, anzugeben, die insbesondere die Kurzschlussfestigkeit des Halbleiterschalters verbessert, so dass auch ein Halbleiterschalter neueren Typs mit einer herkömmlichen Treiberschaltung kurzschlussfest betrieben werden kann.

Die Aufgabe wird erfindungsgemäß durch eine Schaltungsanordnung mit den Merkmalen des Anspruchs 1 gelöst.

Vorteilhafte Ausgestaltungen der Erfindung sind Gegenstand der Unteransprüche.

Eine erfindungsgemäße Schaltungsanordnung zum Betreiben eines Halbleiterschalters, der einen Steueranschluss und zwei Lastanschlüsse aufweist, umfasst eine Treiberschaltung zum Ansteuern des Halbleiterschalters über den Steueranschluss, eine Treiberspannungsversorgung und eine Klemmschaltung. Die Treiberschaltung weist einen ersten Spannungsversorgungsanschluss und einen zweiten Spannungsversorgungsanschluss auf. Die Treiberspannungsversorgung legt eine Einschaltversorgungsspannung zwischen dem ersten Spannungsversorgungsanschluss und einem ersten Lastanschluss zum Einschalten des Halbleiterschalters an. Die Klemmschaltung begrenzt eine Spannung zwischen dem Steueranschluss und dem ersten Lastanschluss auf eine Klemmspannung, die unabhängig von der Einschaltversorgungsspannung ist. Der erste Lastanschluss ist ein Anschluss, der ein Bezugspotential für die Steuerung des Halbleiterschalters definiert. Er ist daher nicht notwendigerweise ein Anschluss, an den tatsächlich eine Last angeschlossen wird, sondern kann als ein separater Anschluss zur Bereitstellung des Bezugspotentials ausgeführt sein.

Der Halbleiterschalter kann insbesondere ein IGBT oder ein MOSFET sein. Im Fall, dass der Halbleiterschalter ein IGBT ist, ist der Steueranschluss ein Gate-Anschluss des IGBT, der erste Lastanschluss ist ein Emitter-Anschluss des IGBT und der zweite Lastanschluss ist ein Kollektor-Anschluss des IGBT. Im Fall, dass der Halbleiterschalter ein MOSFET ist, ist der Steueranschluss ein Gate-Anschluss des MOSFET, der erste Lastanschluss ist ein Source-Anschluss des MOSFET und der zweite Lastanschluss ist ein Drain-Anschluss des MOSFET.

Eine erfindungsgemäße Schaltungsanordnung sieht also vor, die Spannung zwischen dem Steueranschluss und dem ersten Lastanschluss des Halbleiterschalters durch eine Klemmschaltung auf eine Klemmspannung zu begrenzen, die unabhängig von der Einschaltversorgungsspannung der Treiberschaltung ist. Dadurch werden die Klemmspannung und die Einschaltversorgungsspannung der Treiberschaltung voneinander entkoppelt und können unabhängig voneinander dimensioniert werden. Insbesondere ermöglicht dies, einen Spannungsabfall an einer Endstufe der Treiberschaltung auszugleichen, ohne die Klemmspannung zu erhöhen. Dadurch wird in einem Kurzschlussfall die Spannung an dem Steueranschluss des Halbleiterschalters auf die Klemmspannung begrenzt und nicht auf einen von dem Spannungsabfall an der Endstufe der Treiberschaltung abhängigen höheren Wert. Dies erhöht vorteilhaft die Kurzschlussfestigkeit des Halbleiterschalters durch eine Reduzierung der in einem Kurzschlussfall den Halbleiterschalter belastenden Kurzschlussenergie und eine Verlängerung der Kurzschlusszeit.

Die verbesserte Kurzschlussfestigkeit erhöht auch die Freiheiten bei der Bauteilauswahl und der Dimensionierung der Bauteile. Insbesondere ermöglicht die Erfindung, auch Halbleiterschalter mit reduzierten maximal tolerierbaren Kurzschlussenergien und Kurzschlusszeiten, beispielsweise IGBT neuerer Generationen, in Verbindung mit herkömmlichen Treiberschaltungen, an deren Endstufe eine relativ hohe Spannung abfällt, zu verwenden. Dadurch können die Vorteile dieser Halbleiterschalter, beispielsweise deren verbesserte Temperatureigenschaften und verringerte Schaltverluste, ohne hohen Mehraufwand für die Treiberschaltungen genutzt werden.

Darüber hinaus ermöglicht eine erfindungsgemäße Schaltungsanordnung die Stabilisierung der Einschaltspannung des Halbleiterschalters auf einen von einem Spannungsabfall an einer Endstufe der Treiberschaltung unabhängigen Maximalwert. Insbesondere kann eine lastabhängige Verringerung des Spannungsabfalls an der Endstufe nicht zu einer die Klemmspannung überschreitenden Einschaltspannung führen. Die erfindungsgemäße Schaltungsanordnung ermöglicht somit auch eine Kompensation einer Streuung des Spannungsabfalls an der Treiberschaltung.

Eine Ausgestaltung der Erfindung sieht vor, dass die Klemmschaltung eine Klemmdiode aufweist, deren Anode mit dem Steueranschluss verbunden ist. Die Klemmdiode wird leitend, wenn die Spannung zwischen dem Steueranschluss und dem ersten Lastanschluss die Klemmspannung erreicht, und begrenzt ("klemmt") dann diese Spannung auf die Klemmspannung.

Dabei sind die Spannungsversorgungsanschlüsse der Treiberschaltung beispielsweise durch eine Reihenschaltung eines Spannungsteilerwiderstands, einer ersten Z-Diode und einer zwischen den Spannungsteilerwiderstand und die erste Z-Diode geschalteten zweiten Z-Diode miteinander verbunden und die Klemmspannung wird durch eine an der zweiten Z-Diode abfallende Spannung erzeugt. Beispielsweise ist die Kathode der zweiten Z-Diode über einen Verbindungswiderstand mit der Klemmdiode verbunden und die Anode der zweiten Z-Diode ist mit dem ersten Lastanschluss verbunden. Die zweite Z-Diode stabilisiert die Klemmspannung dabei auf einen von der Einschaltversorgungsspannung der Treiberschaltung unabhängigen Wert.

Alternativ sind der erste Lastanschluss und der erste Spannungsversorgungsanschluss beispielsweise über eine Reihenschaltung einer Z-Diode und eines Spannungsteilerwiderstands verbunden und die Klemmspannung wird durch eine an der Z-Diode abfallende Spannung erzeugt. Beispielsweise ist die Kathode der Z-Diode über einen Verbindungswiderstand mit der Klemmdiode verbunden und die Anode der Z-Diode ist mit dem ersten Lastanschluss verbunden. Bei dieser Schaltungsvariante wird die Klemmspannung durch eine Z-Diode in einer Spannungsteilerschaltung erzeugt, die zwischen dem ersten Lastanschluss des Halbleiterschalters und dem ersten Spannungsversorgungsanschluss der Treiberschaltung angeordnet ist.

Alternativ sind der erste Lastanschluss und der erste Spannungsversorgungsanschluss beispielsweise über eine Reihenschaltung eines Spannungsteilerwiderstands und wenigstens einer Spannungsteilerdiode verbunden und die Klemmspannung wird durch eine an dem Spannungsteilerwiderstand abfallende Spannung erzeugt. Auch bei dieser Schaltungsvariante wird die Klemmspannung in einer Spannungsteilerschaltung zwischen dem ersten Lastanschluss des Halbleiterschalters und dem ersten Spannungsversorgungsanschluss der Treiberschaltung erzeugt, wobei jedoch keine Z-Diode verwendet wird.

Bei allen vorgenannten Ausgestaltungen der Erfindung ist die Klemmdiode beispielsweise über einen Klemmschaltungs-Kondensator mit dem ersten Lastanschluss verbunden. Der Klemmschaltungs-Kondensator stabilisiert die Klemmspannung und ermöglicht ein schnelles Eingreifen der Schaltung in einem Kurzschlussfall.

Weitere Schaltungsvarianten sehen vor, dass eine Z-Diode oder eine Transistorschaltung zwischen die Klemmdiode und den ersten Lastanschluss geschaltet ist. Die Transistorschaltung weist beispielsweise einen normal sperrenden n-Kanal-MOSFET mit einem Drain, einem Source und einem Gate auf, wobei das Drain mit der Klemmdiode verbunden ist, das Source mit dem ersten Lastanschluss verbunden ist und das Gate über einen ersten Transistorschaltungswiderstand mit der Klemmdiode und über ein zweiten Transistorschaltungswiderstand mit dem ersten Lastanschluss verbunden ist. Bei diesen beiden Schaltungsvarianten wird die Klemmspannung direkt zwischen dem Steueranschluss und dem ersten Lastanschluss des Halbleiterschalters erzeugt.

Eine weitere Ausgestaltung der Erfindung sieht vor, dass die Klemmschaltung eine zwischen den Steueranschluss und den ersten Lastanschluss geschaltete bidirektionale Suppressordiode aufweist. Dabei ersetzt die Suppressordiode eine Reihenschaltung einer Klemmdiode und einer die Klemmspannung erzeugenden Z-Diode.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: einen Schaltplan einer herkömmlichen Schaltungsan ordnung zum Betreiben eines Halbleiterschalters,
- FIG 2: einen Schaltplan eines ersten Ausführungsbeispiels einer erfindungsgemäßen Schaltungsanordnung,
- FIG 3: einen Schaltplan eines zweiten Ausführungsbeispiels einer erfindungsgemäßen Schaltungsanordnung,
- FIG 4: einen Schaltplan eines dritten Ausführungsbeispiels einer erfindungsgemäßen Schaltungsanordnung,
- FIG 5: einen Schaltplan eines vierten Ausführungsbeispiels einer erfindungsgemäßen Schaltungsanordnung,
- FIG 6: einen Schaltplan eines fünften Ausführungsbeispiels einer erfindungsgemäßen Schaltungsanordnung,
- FIG 7: einen Schaltplan eines sechsten Ausführungsbei spiels einer erfindungsgemäßen Schaltungsanordnung,
- FIG 8: einen Schaltplan eines siebten Ausführungsbeispiels einer erfindungsgemäßen Schaltungsanordnung.

Einander entsprechende Teile sind in den Figuren mit denselben Bezugszeichen versehen.

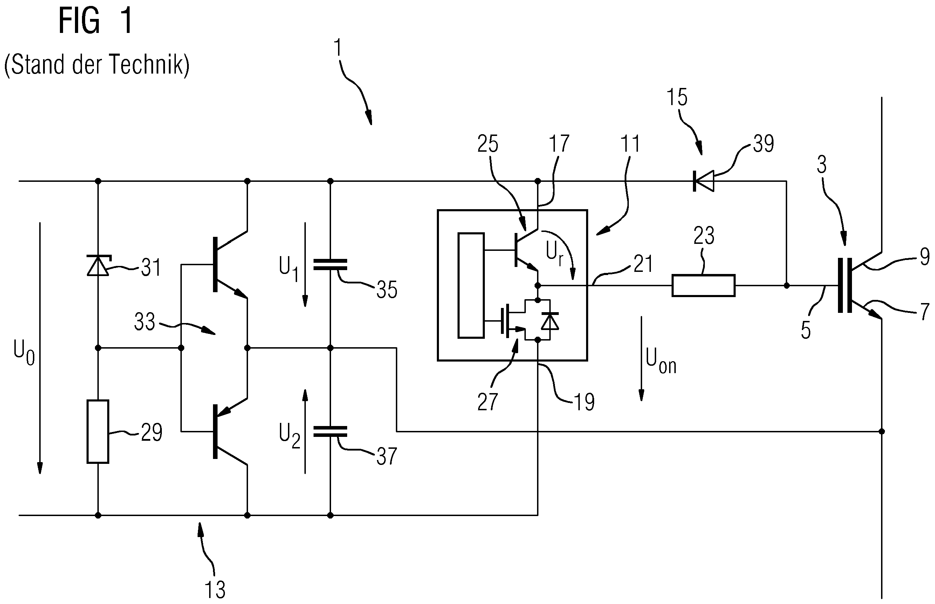

Figur 1 zeigt einen Schaltplan einer herkömmlichen Schaltungsanordnung 1 zum Betreiben eines Halbleiterschalters 3.

Der Halbleiterschalter 3 ist ein IGBT mit einem Steueranschluss 5, der ein Gate-Anschluss des IGBT ist, einem ersten Lastanschluss 7, der ein Emitter-Anschluss des IGBT ist, und einem zweiten Lastanschluss 9, der ein Kollektor-Anschluss des IGBT ist. Dabei ist der erste Lastanschluss 7 ein Anschluss, der ein Bezugspotential für die Steuerung des Halbleiterschalters 3 definiert, das in diesem Fall ein Emitter-Potential des IGBT ist. Der erste Lastanschluss 7 braucht jedoch nicht mit dem üblichen Lastanschluss des Emitters identisch zu sein, sondern kann als ein zusätzlicher Anschluss ("Hilfs-Emitter-Anschluss") ausgeführt sein, der das Bezugspotential bereitstellt und insofern kein "Lastanschluss" im eigentlichen Sinn ist.

Die Schaltungsanordnung 1 umfasst eine Treiberschaltung 11, eine Treiberspannungsversorgung 13 und eine Klemmschaltung 15.

Mit der Treiberschaltung 11 wird der Halbleiterschalter 3 über den Steueranschluss 5 angesteuert. Die Treiberschaltung 11 weist einen ersten Spannungsversorgungsanschluss 17, einen zweiten Spannungsversorgungsanschluss 19 und einen Steuerausgang 21 auf. Der Steuerausgang 21 ist über einen Vorschaltwiderstand 23 mit dem Steueranschluss 5, über eine erste Endstufe 25 der Treiberschaltung 11 mit dem ersten Spannungsversorgungsanschluss 17 und über eine zweite Endstufe 27 der Treiberschaltung 11 mit dem zweiten Spannungsversorgungsanschluss 19 verbunden.

Die Treiberspannungsversorgung 13 legt eine Einschaltversorgungsspannung U₁ zwischen dem ersten Spannungsversorgungsanschluss 17 und dem ersten Lastanschluss 7 und eine Ausschaltversorgungsspannung U₂ zwischen dem zweiten Spannungsversorgungsanschluss 19 und dem ersten Lastanschluss 7 an. Die Treiberspannungsversorgung 13 weist eine die Spannungsversorgungsanschlüsse 17, 19 verbindende Reihenschaltung eines Spannungsteilerwiderstands 29 und einer Spannungsteiler-Z-Diode 31 auf, die eine Versorgungsspannung U₀ in die Einschaltversorgungsspannung U₁ und die Ausschaltversorgungsspannung U₂ teilt. Dabei fällt die Einschaltversorgungsspannung U₁ an der Spannungsteiler-Z-Diode 31 ab, und die Ausschaltversorgungsspannung U₂ fällt an dem Spannungsteilerwiderstand 29 ab. Die Kathode der Spannungsteiler-Z-Diode 31 ist mit dem ersten Spannungsversorgungsanschluss 17 verbunden, die Anode der Spannungsteiler-Z-Diode 31 ist über eine Transistorstufe 33 der Treiberspannungsversorgung 13 mit dem ersten Lastanschluss 7 verbunden. Der erste Lastanschluss 7 ist ferner über einen ersten Kondensator 35 der Treiberspannungsversorgung 13 mit dem ersten Spannungsversorgungsanschluss 17 und über einen zweiten Kondensator 37 der Treiberspannungsversorgung 13 mit dem zweiten Spannungsversorgungsanschluss 19 der Treiberschaltung 11 verbunden.

Die Klemmschaltung 15 weist eine zwischen den Steueranschluss 5 und den ersten Spannungsversorgungsanschluss 17 geschaltete Klemmdiode 39 auf, wobei die Anode der Klemmdiode 39 mit dem Steueranschluss 5 verbunden ist und die Kathode der Klemmdiode 39 mit dem ersten Spannungsversorgungsanschluss 17 verbunden ist.

Die Klemmdiode 39 begrenzt eine Spannung zwischen dem Steueranschluss 5 und dem ersten Lastanschluss 7 des Halbleiterschalters 3 auf die Einschaltversorgungsspannung U₁. Die Einschaltversorgungsspannung U₁ ist die Summe einer Einschaltspannung Uₒₙ, die zwischen dem Steuerausgang 21 der Treiberschaltung 11 und dem ersten Lastanschluss 7 des Halbleiterschalters 3 anliegt, und einer Endstufenspannung Uᵣ, die an der ersten Endstufe 25 abfällt. Die Klemmdiode 39 dient der Begrenzung der Spannung zwischen dem Steueranschluss 5 und dem ersten Lastanschluss 7 in einem Kurzschlussfall, in dem diese Spannung ohne die Klemmdiode 39 über die Einschaltversorgungsspannung U₁ anwüchse.

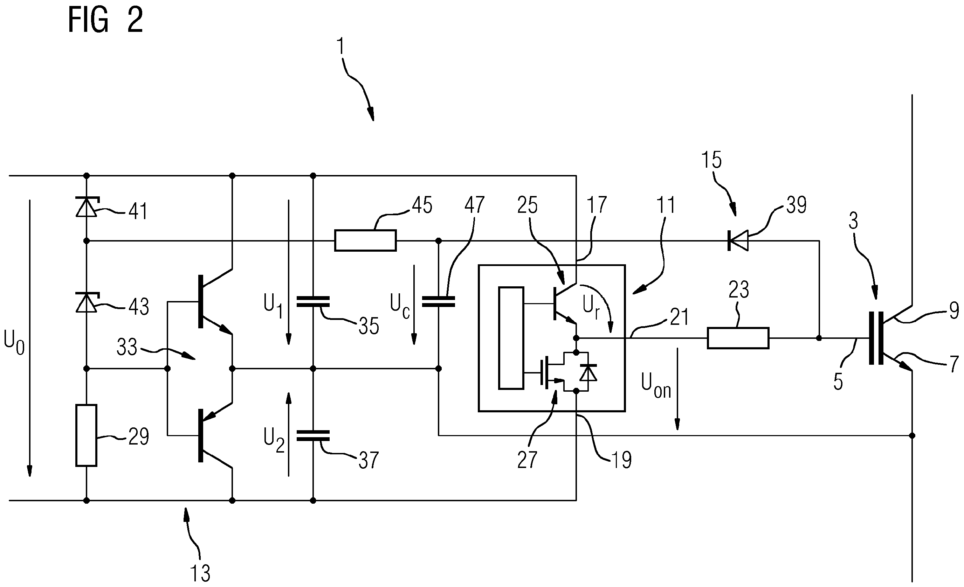

Figur 2 zeigt einen Schaltplan eines ersten Ausführungsbeispiels einer erfindungsgemäßen Schaltungsanordnung 1 zum Betreiben des Halbleiterschalters 3. Die Schaltungsanordnung 1 unterscheidet sich von der in Figur 1 gezeigten Schaltungsanordnung 1 dadurch, dass die Spannungsteiler-Z-Diode 31 durch eine Reihenschaltung einer ersten Z-Diode 41 und einer zwischen den Spannungsteilerwiderstand 29 und die erste Z-Diode 41 geschalteten zweiten Z-Diode 43 ersetzt ist, und dass die Kathode der Klemmdiode 39 nicht mit dem ersten Spannungsversorgungsanschluss 17 der Treiberschaltung 11, sondern über einen Verbindungswiderstand 45 mit der Kathode der zweiten Z-Diode 43 und über einen Klemmschaltungs-Kondensator 47 mit dem ersten Lastanschluss 7 verbunden ist. Dadurch wird die Spannung zwischen dem Steueranschluss 5 und dem ersten Lastanschluss 7 des Halbleiterschalters 3 durch die Klemmdiode 39 auf eine Klemmspannung U_{C} begrenzt, die durch eine an der zweiten Z-Diode 43 abfallende Spannung erzeugt wird und unabhängig von der Einschaltversorgungsspannung U₁ ist.

Insbesondere wird mit der in Figur 2 gezeigten Schaltungsanordnung 1 die Spannung zwischen dem Steueranschluss 5 und dem ersten Lastanschluss 7 in einem Kurzschlussfall auf eine Klemmspannung U_{C} begrenzt, die nicht von der Endstufenspannung Uᵣ der Treiberschaltung 11 abhängt und einer vorgesehenen Einschaltspannung Uₒₙ angepasst ist. Dadurch wird überdies auch die Einschaltspannung Uₒₙ auf einen von der Endstufenspannung Uᵣ unabhängigen Wert stabilisiert. Bei der in Figur 1 gezeigten Schaltungsanordnung 1 ist die Einschaltspannung Uₒₙ nämlich abhängig von der ihrerseits lastabhängigen Endstufenspannung Uᵣ: verringert sich die Endstufenspannung Uᵣ, so vergrößert sich die Einschaltspannung Uₒₙ. Bei der in Figur 2 gezeigten Schaltungsanordnung 1 wird die Einschaltspannung Uₒₙ dagegen auf einen von der Klemmspannung U_{C} abhängigen Wert begrenzt. Der Wert der Einschaltspannung Uₒₙ hat großen Einfluss auf die Energieverluste beim Betrieb des Halbleiterschalters 3 und auf die elektromagnetische Verträglichkeit des Betriebs des Halbleiterschalters 3. Durch die Stabilisierung der Einschaltspannung Uₒₙ werden Streuungen der Energieverluste und der elektromagnetischen Verträglichkeit reduziert. Dadurch können bei der Auslegung der Schaltungsanordnung 1 Sicherheitsreserven reduziert werden, die diese Streuungen berücksichtigen.

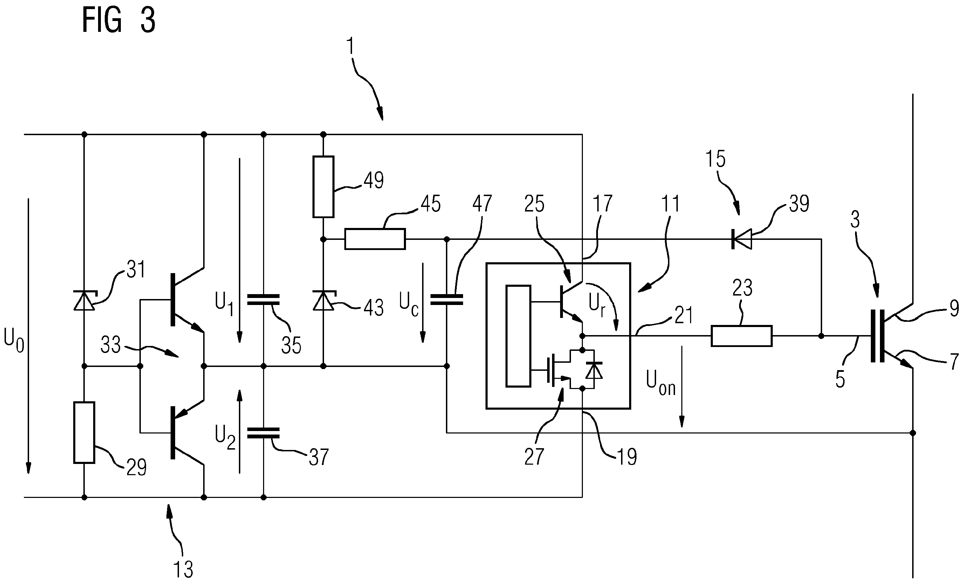

Die Figuren 3 bis 7 zeigen jeweils einen Schaltplan eines weiteren Ausführungsbeispiels einer erfindungsgemäßen Schaltungsanordnung 1, mit der die Spannung zwischen dem Steueranschluss 5 und dem ersten Lastanschluss 7 auf eine Klemmspannung U_{C} begrenzt wird, die unabhängig von der Einschaltversorgungsspannung U₁ ist.

Das in Figur 3 gezeigte Ausführungsbeispiel unterscheidet sich von der in Figur 1 gezeigten Schaltungsanordnung 1 dadurch, dass der erste Lastanschluss 7 und der erste Spannungsversorgungsanschluss 17 über eine Reihenschaltung einer zweiten Z-Diode 43, deren Anode mit dem ersten Lastanschluss 7 verbunden ist, und eines zweiten Spannungsteilerwiderstands 49 verbunden sind, und dass die Kathode der Klemmdiode 39 nicht mit dem ersten Spannungsversorgungsanschluss 17 der Treiberschaltung 11, sondern über einen Verbindungswiderstand 45 mit der Kathode der zweiten Z-Diode 43 und über einen Klemmschaltungs-Kondensator 47 mit dem ersten Lastanschluss 7 verbunden ist. Die Klemmspannung U_{C} wird durch eine an der zweiten Z-Diode 43 abfallende Spannung erzeugt.

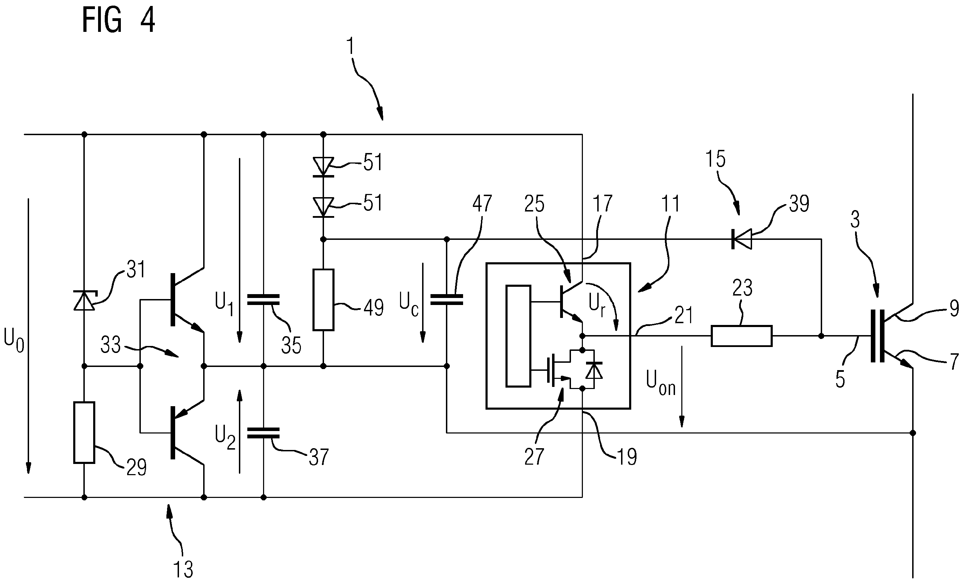

Das in Figur 4 gezeigte Ausführungsbeispiel unterscheidet sich von der in Figur 1 gezeigten Schaltungsanordnung 1 dadurch, dass der erste Lastanschluss 7 und der erste Spannungsversorgungsanschluss 17 über eine Reihenschaltung eines mit dem ersten Lastanschluss 7 verbundenen zweiten Spannungsteilerwiderstands 49 und zweier Spannungsteilerdioden 51 verbunden sind, und dass die Kathode der Klemmdiode 39 nicht mit dem ersten Spannungsversorgungsanschluss 17 der Treiberschaltung 11, sondern mit dem von dem ersten Lastanschluss 7 abgewandten Endpol des zweiten Spannungsteilerwiderstands 49 und über einen Klemmschaltungs-Kondensator 47 mit dem ersten Lastanschluss 7 verbunden ist. Die Klemmspannung U_{C} wird durch eine an dem zweiten Spannungsteilerwiderstand 49 abfallende Spannung erzeugt. Statt zweier Spannungsteilerdioden 51 kann auch eine andere Anzahl von Spannungsteilerdioden 51 verwendet werden.

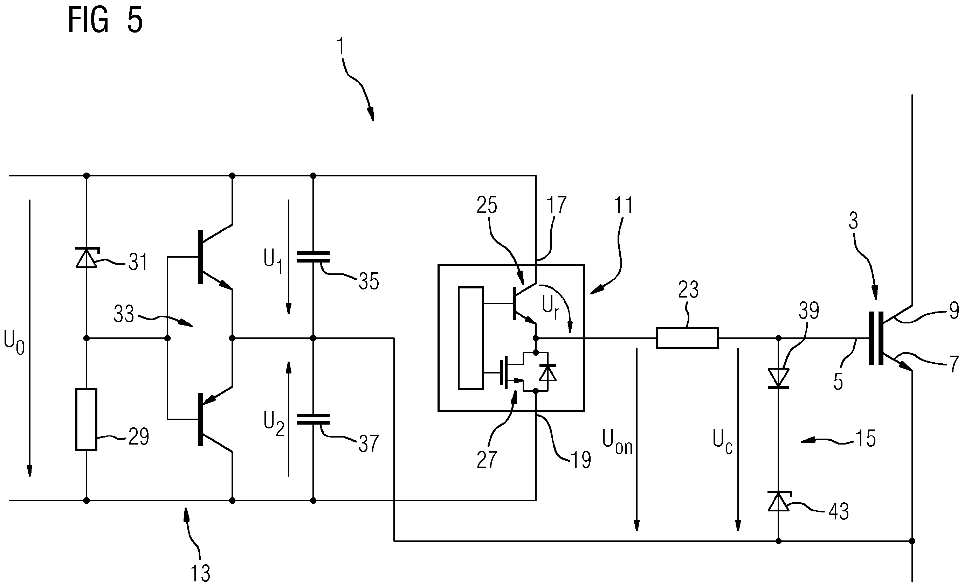

Das in Figur 5 gezeigte Ausführungsbeispiel unterscheidet sich von der in Figur 1 gezeigten Schaltungsanordnung 1 dadurch, dass die Kathode der Klemmdiode 39 nicht mit dem ersten Spannungsversorgungsanschluss 17 der Treiberschaltung 11, sondern über eine zweite Z-Diode 43 mit dem ersten Lastanschluss 7 verbunden ist, wobei die Anode der zweiten Z-Diode 43 mit dem ersten Lastanschluss 7 verbunden ist und die Kathode der zweiten Z-Diode 43 mit der Kathode der Klemmdiode 39 verbunden ist. Die Klemmspannung U_{C} wird durch eine an der zweiten Z-Diode 43 abfallende Spannung erzeugt.

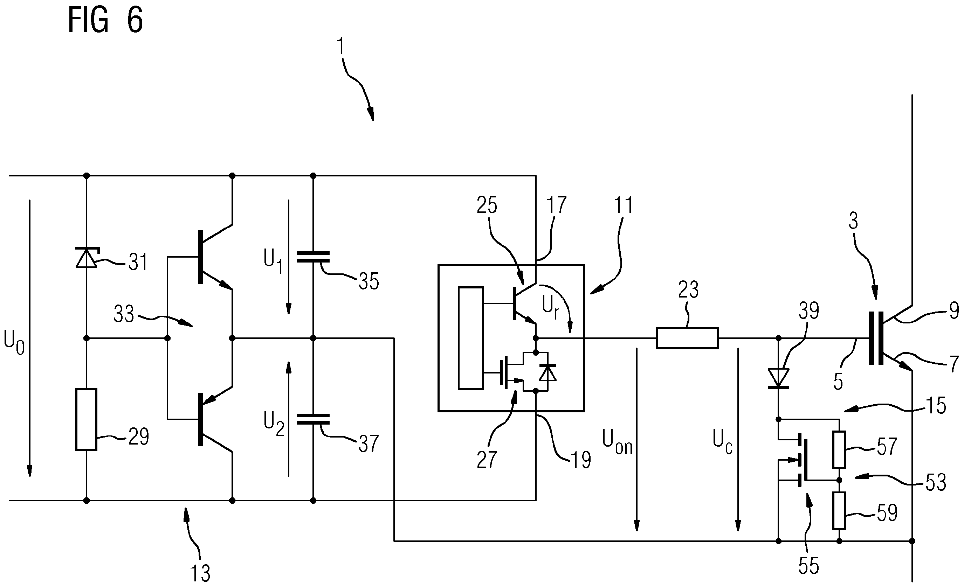

Das in Figur 6 gezeigte Ausführungsbeispiel unterscheidet sich von der in Figur 1 gezeigten Schaltungsanordnung 1 dadurch, dass die Kathode der Klemmdiode 39 nicht mit dem ersten Spannungsversorgungsanschluss 17 der Treiberschaltung 11, sondern über eine die Klemmspannung U_{C} erzeugende Transistorschaltung 53 mit dem ersten Lastanschluss 7 verbunden ist. Die Transistorschaltung 53 weist einen normal sperrenden n-Kanal-MOSFET 55 auf. ein Drain des n-Kanal-MOSFET 55 ist mit der Klemmdiode 39 verbunden. Ein Source des n-Kanal-MOSFET 55 ist mit dem ersten Lastanschluss 7 verbunden. Ein Gate des n-Kanal-MOSFET 55 ist über einen ersten Transistorschaltungswiderstand 57 mit der Klemmdiode 39 und über ein zweiten Transistorschaltungswiderstand 59 mit dem ersten Lastanschluss 7 verbunden.

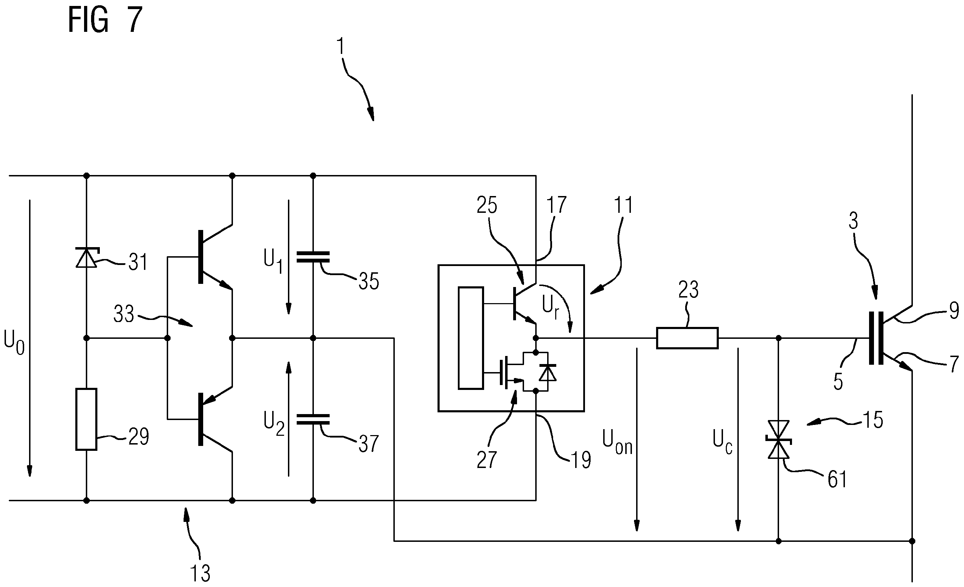

Das in Figur 7 gezeigte Ausführungsbeispiel unterscheidet sich von der in Figur 1 gezeigten Schaltungsanordnung 1 dadurch, dass es statt einer zwischen den Steueranschluss 5 und den ersten Spannungsversorgungsanschluss 17 der Treiberschaltung 11 geschalteten Klemmdiode 39 eine zwischen den Steueranschluss 5 und den ersten Lastanschluss 7 geschaltete bidirektionale Suppressordiode 61 aufweist, die die Klemmspannung U_{C} erzeugt.

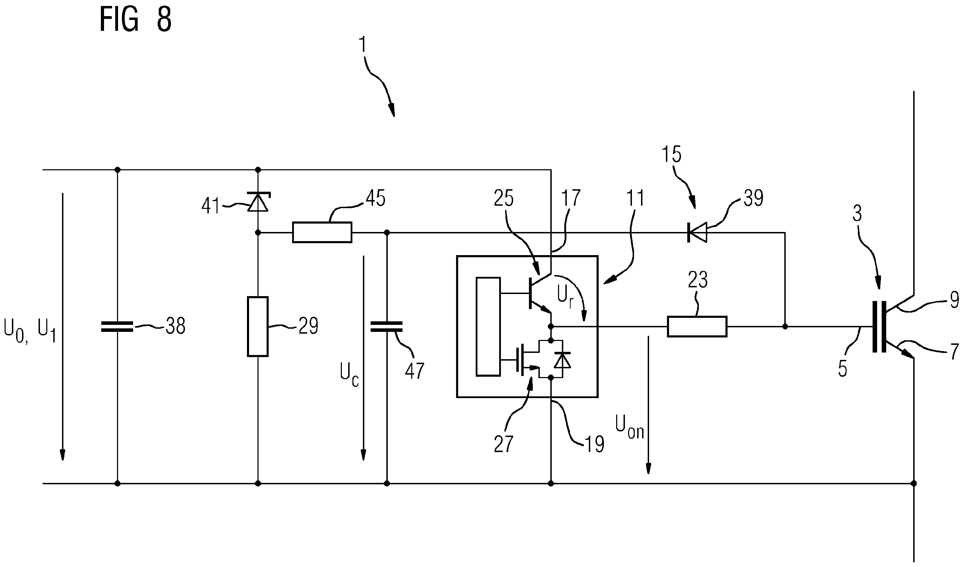

Figur 8 zeigt einen Schaltplan eines Ausführungsbeispiels einer erfindungsgemäßen Schaltungsanordnung 1, das sich von dem in Figur 2 gezeigten Ausführungsbeispiel dadurch unterscheidet, dass die zweite Z-Diode 43, die Transistorstufe 33 und die Kondensatoren 35, 37 entfallen, parallel zur Reihenschaltung der Z-Diode 41 und des Spannungsteilerwiderstands 29 ein Kondensator 38 geschaltet ist und der zweite Spannungsversorgungsanschluss 19 mit dem ersten Lastanschluss 7 und mit dem von der Z-Diode 41 abgewandten Endpol des Spannungsteilerwiderstands 29 verbunden ist. Die Gesamtversorgungsspannung U₀ liegt zwischen den beiden Spannungsversorgungsanschlüssen 17, 19 und damit auch zwischen dem ersten Spannungsversorgungsanschluss 17 und dem ersten Lastanschluss 7 an. Mit anderen Worten stimmt die Einschaltversorgungsspannung U₁ mit der Versorgungsspannung U₀ überein und die Ausschaltversorgungsspannung U₂ beträgt 0 V. Die Klemmspannung U_{C} wird durch die an dem Spannungsteilerwiderstand 29 abfallende Spannung erzeugt. Das in Figur 8 gezeigte Ausführungsbeispiel kann auch dahingehend abgewandelt werden, dass die Z-Diode 41 und der Spannungsteilerwiderstand 29 vertauscht werden, so dass die Klemmspannung U_{C} durch die an der Z-Diode 41 abfallende Spannung erzeugt wird.

Die in den Figuren 2 bis 8 gezeigten Schaltungsanordnungen 1 können analog für einen MOSFET statt für einen IGBT eingesetzt werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Schaltungsanordnung (1) zum Betreiben eines Halbleiterschalters (3), der einen Steueranschluss (5) und zwei Lastanschlüsse (7, 9) aufweist, die Schaltungsanordnung (1) umfassend
- eine Treiberschaltung (11) zum Ansteuern des Halbleiterschalters (3) über den Steueranschluss (5), wobei die Treiberschaltung (11) einen ersten Spannungsversorgungsanschluss (17) und einen zweiten Spannungsversorgungsanschluss (19) aufweist,
- eine Treiberspannungsversorgung (13), die eine Einschaltversorgungsspannung (U₁) zwischen dem ersten Spannungsversorgungsanschluss (17) und einem ersten Lastanschluss (7) zum Einschalten des Halbleiterschalters (3) anlegt,
- eine Klemmschaltung (15) zur Begrenzung einer Spannung zwischen dem Steueranschluss (5) und dem ersten Lastanschluss (7) auf eine Klemmspannung (U_{C}), die unabhängig von der Einschaltversorgungsspannung (U₁) ist.

2. Schaltungsanordnung (1) nach Anspruch 1, wobei der Halbleiterschalter (3) ein Bipolartransistor mit isoliertem Gate ist, der Steueranschluss (5) ein Gate-Anschluss des Bipolartransistors mit isoliertem Gate ist, der erste Lastanschluss (7) ein Emitter-Anschluss des Bipolartransistors mit isoliertem Gate ist und der zweite Lastanschluss (9) ein Kollektor-Anschluss des Bipolartransistors mit isoliertem Gate ist.

3. Schaltungsanordnung (1) nach Anspruch 1, wobei der Halbleiterschalter (3) ein Metall-Oxid-Halbleiter-Feldeffekttransistor ist, der Steueranschluss (5) ein Gate-Anschluss des Metall-Oxid-Halbleiter-Feldeffekttransistors ist, der erste Lastanschluss (7) ein Source-Anschluss des Metall-Oxid-Halbleiter-Feldeffekttransistors ist und der zweite Lastanschluss (9) ein Drain-Anschluss des Metall-Oxid-Halbleiter-Feldeffekttransistors ist.

4. Schaltungsanordnung (1) nach einem der Ansprüche 1 bis 3, wobei die Klemmschaltung (15) eine Klemmdiode (39) aufweist, deren Anode mit dem Steueranschluss (5) verbunden ist.

5. Schaltungsanordnung (1) nach Anspruch 4, wobei die Spannungsversorgungsanschlüsse (17, 19) durch eine Reihenschaltung eines Spannungsteilerwiderstands (29), einer ersten Z-Diode (41) und einer zwischen den Spannungsteilerwiderstand (29) und die erste Z-Diode (41) geschalteten zweiten Z-Diode (43) miteinander verbunden sind und die Klemmspannung (U_{C}) durch eine an der zweiten Z-Diode (43) abfallende Spannung erzeugt wird.

6. Schaltungsanordnung (1) nach Anspruch 5, wobei die Kathode der zweiten Z-Diode (43) über einen Verbindungswiderstand (45) mit der Klemmdiode (39) verbunden ist und die Anode der zweiten Z-Diode (43) mit dem ersten Lastanschluss (7) verbunden ist.

7. Schaltungsanordnung (1) nach Anspruch 4, wobei der erste Lastanschluss (7) und der erste Spannungsversorgungsanschluss (17) über eine Reihenschaltung einer Z-Diode (43) und eines Spannungsteilerwiderstands (49) verbunden sind und die Klemmspannung (U_{C}) durch eine an der Z-Diode (43) abfallende Spannung erzeugt wird.

8. Schaltungsanordnung (1) nach Anspruch 7, wobei die Kathode der Z-Diode (43) über einen Verbindungswiderstand (45) mit der Klemmdiode (39) verbunden ist und die Anode der Z-Diode (43) mit dem ersten Lastanschluss (7) verbunden ist.

9. Schaltungsanordnung (1) nach Anspruch 4, wobei der erste Lastanschluss (7) und der erste Spannungsversorgungsanschluss (17) über eine Reihenschaltung eines Spannungsteilerwiderstands (49) und wenigstens einer Spannungsteilerdiode (51) verbunden sind und die Klemmspannung (U_{C}) durch eine an dem Spannungsteilerwiderstand (49) abfallende Spannung erzeugt wird.

10. Schaltungsanordnung (1) nach Anspruch 4, wobei der erste Lastanschluss (7) direkt mit dem zweiten Spannungsversorgungsanschluss (19) und über eine Reihenschaltung eines Spannungsteilerwiderstands (29) und einer Z-Diode (41) mit dem ersten Spannungsversorgungsanschluss (17) verbunden ist und die Klemmspannung (U_{C}) durch eine an dem Spannungsteilerwiderstand (29) oder an der Z-Diode (41) abfallende Spannung erzeugt wird.

11. Schaltungsanordnung (1) nach einem der Ansprüche 4 bis 10, wobei die Klemmdiode (39) über einen Klemmschaltungs-Kondensator (47) mit dem ersten Lastanschluss (7) verbunden ist.

12. Schaltungsanordnung (1) nach Anspruch 4, wobei eine Z-Diode (43) zwischen die Klemmdiode (39) und den ersten Lastanschluss (7) geschaltet ist.

13. Schaltungsanordnung (1) nach Anspruch 4, wobei eine Transistorschaltung (53) zwischen die Klemmdiode (39) und den ersten Lastanschluss (7) geschaltet ist.

14. Schaltungsanordnung (1) nach Anspruch 13, wobei die Transistorschaltung (53) einen normal sperrenden n-Kanal-Metall-Oxid-Halbleiter-Feldeffekttransistor (55) mit einem Drain, einem Source und einem Gate aufweist, wobei das Drain mit der Klemmdiode (39) verbunden ist, das Source mit dem ersten Lastanschluss (7) verbunden ist und das Gate über einen ersten Transistorschaltungswiderstand (57) mit der Klemmdiode (39) und über ein zweiten Transistorschaltungswiderstand (59) mit dem ersten Lastanschluss (7) verbunden ist.

15. Schaltungsanordnung (1) nach einem der Ansprüche 1 bis 3, wobei die Klemmschaltung (15) eine zwischen den Steueranschluss (5) und den ersten Lastanschluss (7) geschaltete bidirektionale Suppressordiode (61) aufweist.
